(19) Europäisches Patentamt
European Patent Office
Office européen des brevets

(11) Veröffentlichungsnummer: **0 315 216**
**A2**

# (12) EUROPÄISCHE PATENTANMELDUNG

(21) Anmeldenummer: **88119435.1**

(51) Int. Cl.[4]: **C08G 73/10**

(22) Anmeldetag: **14.05.84**

(30) Priorität: **18.05.83 CH 2690/83**
**12.10.83 CH 5571/83**

(43) Veröffentlichungstag der Anmeldung:
**10.05.89 Patentblatt 89/19**

(60) Veröffentlichungsnummer der früheren Anmeldung nach Art. 76 EPÜ: **0 132 221**

(84) Benannte Vertragsstaaten:
**BE CH DE FR GB IT LI NL SE**

(71) Anmelder: **CIBA-GEIGY AG**
**Klybeckstrasse 141**
**CH-4002 Basel(CH)**

(72) Erfinder: **Pfeifer, Josef, Dr.**
**Brunnmattstrasse 32**
**CH-4102 Therwil(CH)**

## (54) Polyimide, Verfahren zu deren Herstellung und deren Verwendung.

(57) Homo- und Copolyimide aus aromatischen Tetracarbonsäuren und aromatischen Diaminen, die in beiden Orthostellungen mindestens eines N-Atomes durch Alkyl, Alkoxy, Alkoxyalkyl, Cycloalkyl oder Aralkyl substituiert sind, sind in organischen Lösungsmitteln löslich und weisen erhöhte Glasumwandlungstemperaturen und damit sehr gut Thermostabilitäten auf. Die Polyimide eignen sich zur Herstellung von Filmen und Schutzüberzügen.

EP 0 315 216 A2

## Polyimide, Verfahren zu deren Herstellung und deren Verwendung

Die vorliegende Erfindung betrifft Homo- und Copolyimide aus aromatischen Tetracarbonsäuren mit Ausnahme der Benzophenontetracarbonsäure und Diaminen, wobei mindestens 5-Mol-% der Diamine aromatische Diamine sind, die in beiden Orthostellung zu mindestens einem N-Atom durch Alkyl, Cycloalkyl, Alkoxy, Aloxyalkyl oder Aralkyl substituiert sind, ein Verfahren zu deren Herstellung und deren Verwendung zur Herstellung von Filmen und Schutzüberzügen.

Polyimide sind Kunststoffe mit wertvollen thermomechanischen Eigenschaften. Auf Grund ihrer hohen Schmelzbereiche können sie jedoch nicht mit den für Thermoplaste üblichen Formgebungsverfahren verarbeitet werden. Es sind daher lösliche Polyimide entwickelt worden, die als Lacke zur Bildung von Ueberzugsschichten mit hoher Wärmebeständigkeit verwendet werden können, vgl. DE-AS 19 62 588 und US-PS 3,787,367. Mit der Entwicklung der Elektronik und Halbleitertechnologie werden an Polyimide z.B. als Isolier- und Schutzfilme besonders hohe Anforderungen an deren Thermostabilität gestellt, welche die bekannten Polyimide nicht immer zu erfüllen vermögen.

Es wurde nun gefunden, dass man lösliche Polyimide mit erhöhter Thermostabilität erhält, wenn man mindestens ein aromatisches Diamin verwendet, das in beiden Orthostellungen zu mindestens einer $NH_2$-Gruppe substituiert ist.

Gegenstand der Erfindung sind Homo- und Copolyimide aus mindestens einer aromatischen Tetracarbonsäure und mindestens einem aromatischen Diamin, die im wesentlichen aus 5 bis 100 Mol-% mindestens eines Strukturelements der Formel I

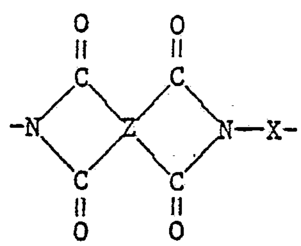

(I)

und 95-0 Mol-% mindestens eines Strukturelementes der Formel II

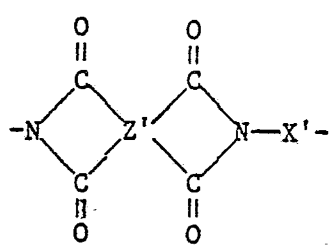

(II),

bestehen, worin

Z einen unsubstituierten oder substituierten vierwertigen aromatischen Rest mit Ausnahme eines Restes der Benzophenontetracarbonsäure darstellt, an den je. zwei Carbonylgruppen in Ortho- oder Peristellung gebunden sind,

X den zweiwertigen Rest eines aromatischen Diamines bedeutet,

Z′ die gleiche Bedeutung wie Z hat, oder ein von Z verschiedener vierwertiger aromatischer Rest mit Ausnahme eines Restes der Benzophenontetracarbonsäure ist und X′ der zweiwertige, von X verschiedene Rest eines organischen Diamines ist, die dadurch gekennzeichnet sind, dass der aromatische Rest von X in beiden Orthostellung zu mindestens einem N-Atom durch Alkyl, Cycloalkyl, Alkoxy, Alkoxyalkyl oder Aralkyl substituiert ist oder dass zwei benachbarte C-Atome des aromatischen Restes durch Alkylen substituiert sind.

Die Strukturelemente der Formel I sind bevorzugt in einer Menge von 20-100 Mol-%, besonders 50-100 Mol-% und insbesondere 80-100 Mol-% und die Strukturelemente der Formel II bevorzugt in einer Menge von 80 bis 0 Mol-%, besonders 50 bis 0 Mol-% und insbesondere 20 bis 0 Mol-% enthalten.

Als aromatischer Rest stellt X bevorzugt einen zweiwertigen, ein- oder zweikernigen Phenylrest dar. Die Substituenten von X können als lineares oder verzweigtes Alkyl und Alkoxy 1 bis 20, bevorzugt 1 bis 6 und besonders 1 bis 4 C-Atome, als lineares oder verzweigtes Alkoxyalkyl 2 bis 12, besonders 2 bis 6 C-Atome, als Alkylen 3 oder 4 C-Atome, als Cycloalkyl 5 bis 8, besonders 5 oder 6 Ringkohlenstoffatome und als Aralkyl 7 bis 12 C-Atome enthalten. Das Alkoxyalkyl ist bevorzugt Alkoxymethyl und das Aralkyl Benzyl.

Beispiele für Substituenten sind: Methyl, Aethyl, Propyl, Isopropyl, n-Butyl, Isobutyl, Tertiarbutyl, Pentyl, Hexyl, Octyl, Dodecyl, Tetradecyl, Eicosyl, Cyclopentyl, Cyclohexyl, Methylcyclohexyl, Methoxy, Aethoxy, Propoxy, Butoxy, Pentoxy, Hexoxy, Methoxymethyl, Methoxyäthyl, Aethoxymethyl, Propoxymethyl, Butoxymethyl, Benzyl, Methylbenzyl und Phenylaethyl. Bevorzugte Reste sind Methoxymethyl, Aethoxymethyl, Methyl, Aethyl, Isopropyl, Trimethylen und Tetramethylen. Besonders bevorzugt ist Isopropyl, Aethyl und insbesondere Methyl.

X kann als substituierter aromatischer Rest 8 bis 30, besonders 8 bis 25 C-Atome enthalten. Der aromatische Rest ist bevorzugt ein Pyridinrest und besonders ein Kohlenwasserstoffrest, der durch Alkyl, Alkoxyalkyl, Alkoxy, Trimethylen oder Tetramethylen substituiert ist. Der aromatische Rest kann weitere Substituenten enthalten, z.B. Halogenid wie Cl oder Br. In einer bevorzugten Untergruppe sind die aromatischen Reste als einkernige Reste Phenylenreste und als zweikernige Reste Naphthylen oder Bisphenylenreste.

Eine bevorzugte Untergruppe von erfindungsgemässen Polyimiden sind solche, in denen X als aromatischer Rest den Formeln III, IIIa und/oder IIIb entspricht,

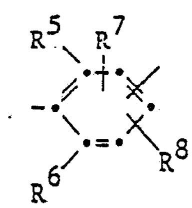 (III) 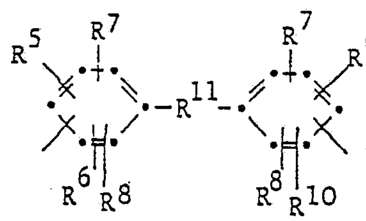 (IIIa) 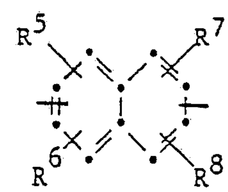 (IIIb)

worin in Formel III die freien Bindungen in Meta- oder Parastellung zueinander stehen, in Formel IIIa die freien Bindungen bevorzugt in Meta- oder Parastellung zur $R^{11}$-Gruppe stehen und $R^5$ und $R^6$ in den beiden Orthostellungen der freien Bindung gebunden sind, und in Formel IIIb die freien Bindungen in 2-, 3-, 6- und 7-Stellung gebunden sind und $R^5$ und $R^6$ sich in den beiden Orthostellungen der freien Bindungen befinden, $R^{11}$ für eine direkte Bindung, -O-, -S-, -SS-, -SO-, $-SO_2-$, -CO-, -COO-, -NH-, -N-Alkyl mit 1 bis 6 C-Atomen im Alkyl,

$-\overset{|}{N}$-Phenyl, $-\overset{|}{N}$-Benzyl, -CONH-, -CON-Alkyl- mit 1 bis 6 C-Atomen im Alkyl, -CON-Phenyl-, -CON-Benzyl-,

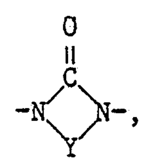, worin Y für $-\overset{O}{\overset{\|}{C}}-\overset{O}{\overset{\|}{C}}-$, $-\overset{O}{\overset{\|}{C}}-C(R^{17})(R^{17})-$ oder $-\overset{O}{\overset{\|}{C}}-\overset{R^{17}}{\overset{|}{N}}-\overset{O}{\overset{\|}{C}}-$ steht und

$R^{17}$ ein Wasserstoffatom, $C_1$-$C_6$-Alkyl oder Phenyl bedeutet, lineares oder verzweigtes Alkylen mit 1 bis 3 C-Atomen, gegebenenfalls durch Cl oder F substituiertes Alkyliden mit 2 bis 12 C-Atomen, Cycloalkyliden mit 5 oder 6 Ringkohlenstoffatomen, Phenylen, Phenylendioxy, oder die Gruppe

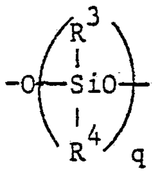 oder 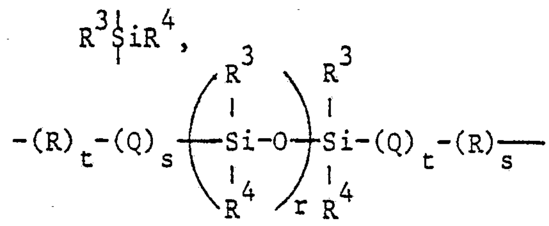 steht, worin $R^3$ und $R^4$ Alkyl oder Alkoxy mit 1 bis 6 C-Atomen, Phenyl, Benzyl, Phenyloxy oder Benzyloxy sind, r eine Zahl von 1 bis 10, to 0 oder 1 und S 0 oder 1 ist, und R -O- oder -S- und Q $C_1$-$C_6$-Alkylen bedeuten, und q für eine Zahl von 1 bis 100 steht, $R^5$ und $R^6$ Alkyl, oder Alkoxy mit 1 bis 12 C-Atomen, Alkoxyalkyl mit 2 bis 12 C-Atomen Cyclopentyl, Cyclohexyl oder Benzyl sind oder in den Formeln III oder IIIa $R^5$ und $R^7$ in Nachbarstellung gebunden sind und zusammen Trimethylen oder Tetramethylen bedeuten, wobei $R^6$ auch ein Wasserstoffatom sein kann, $R^7$ und $R^8$ ein Wasserstoffatom sind oder unabhängig die Bedeutung von $R^5$ und $R^6$ haben, und $R^9$ und $R^{10}$ ein Wasserstoffatom sind, unabhängig die Bedeutung von $R^5$ und $R^6$ haben oder $R^7$ und $R^9$ in Formel IIIa zusammen Trimethylen oder Tetramethylen sind. $R^5$ und $R^6$ sind bevorzugt Alkyl mit 1 bis 6 C-Atomen, besonders Methyl, Aethyl, n-Propyl und Isopropyl. Die freien Bindungen der Formel IIIa befinden sich bevorzugt in Meta- und besonders Parastellung zur $R^{11}$-Gruppe. Das Alkyl in den $R^{11}$-Resten kann z.B. Methyl, Aethyl, Propyl, Isopropyl, n-Butyl oder Pentyl sein. $R^{11}$ als Alkylen ist bevorzugt Aethylen und besonders Methylen. Als Alkyliden enthält $R^{11}$ bevorzugt 2 bis 6 C-Atome. Beispiele sind Aethyliden, 2,2-Butyliden, 2,2- oder 3,3-Pentyliden, Hexafluorpropyliden und besonders 2,2-Propyliden. $R^{11}$ als Cycloalkyliden kann z.B. Cyclopentyliden und besonders Cyclohexyliden sein. Die $R^{11}$-Gruppe ist bevorzugt eine direkte Bindung, -O-, -S-, $-SO_2-$, -CO-, Alkylen und Alkyliden. Besonders bevorzugt ist $R^{11}$ eine direkte Bindung -O-, und insbesondere -CO- oder $-CH_2-$. $R^3$ und $R^4$ sind bevorzugt Alkyl, besonders Methyl oder Phenyl. R steht bevorzugt für -O- und Q bevorzugt für Methylen oder Aethylen, q ist bevorzugt eine Zahl von 1 bis 10 und r eine Zahl von 1-20, besonders 1-10.

Eine weitere Gruppe von Diaminresten sind solche der Formel

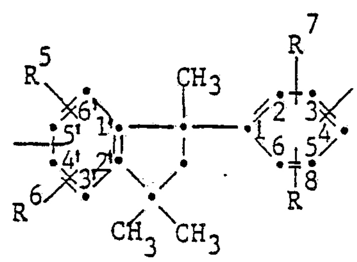 ,

worin die freie Bindung in 4′- oder 5′-Stellung gebunden ist und die andere in 3-, 5-, und bevorzugt 4-Stellung, $R^5$ und $R^6$ und/oder $R^7$ und $R^8$ sich in den Orthostellungen der freien Bindung befinden und für Alkyl oder Alkoxy mit 1 bis 12 C-Atomen oder Alkoxyalkyl mit 2 bis 12 C-Atomen stehen.

Eine besonders bevorzugte Untergruppe von erfindungsgemässen Polyimiden sind jene, in denen X in Formel I Resten der Formeln

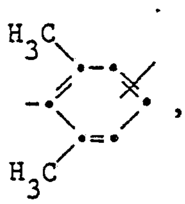 , 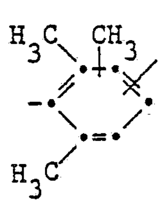 , 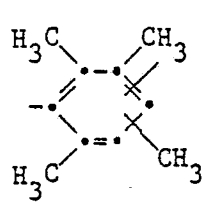 , 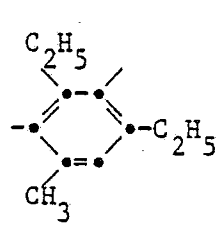

entsprechen, worin die freien Bindungen in Meta- oder Parastellung zueinander stehen, oder der Formel

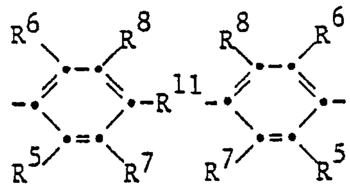

entsprechen, worin $R^5$ und $R^6$ unabhängig Methyl, Aethyl, n-Propyl oder Isopropyl und $R^7$ und $R^8$ ein Wasserstoffatom sind oder die Bedeutung von $R^5$ haben oder $R^5$ und $R^7$ zusammen Tri oder Tetramethylen bedeuten und $R^6$ und $R^8$ ein Wasserstoffatom sind, und $R^{11}$ eine direkte Bindung, $CH_2$, 2,2-Propyliden oder CO ist. Unter diesen zweikernigen Resten sind besonders solche bevorzugt, in denen $R^5$, $R^6$, $R^7$ und $R^8$ für Methyl stehen. Copolyimide, die mindestens 2 verschiedene Reste dieser Formeln enthalten, sind eine weitere bevorzugte Ausführungsform der Erfindung.

Erfindungsgemässe Copolyimide enthalten mindestens zwei verschiedene Strukturelemente, wobei sich die Anzahl an verschiedenen Strukturelementen im wesentlichen nach den gewünschten Eigenschaften und dem Anwendungsgebiet richten. Bevorzugt enthalten sie 2 bis 4 verschiedene Strukturelemente, wobei sich die Strukturelemente nur im Rest X der Formel I unterscheiden können. In einer besonders bevorzugten Aus führungsform solcher Copolyimide sind Strukturelemente von Orthodisubstituierten Phenylenen enthalten, besonders von 1,3-Phenylenen.

Beispiele für X sind:

2,6-Dimethyl-1,4- oder 1,3-phenylen, 2,6-Diäthyl-1,4- oder 1,3-phenylen, 2,6-Dimethyl-5-chlor-1,4- oder 1,3-phenylen, 2-Methyl-6-äthyl-1,4- oder 1,3-phenylen, 2-Methyl-6-isopropyl-1,4- oder 1,3-phenylen, 2,6-Diisopropyl-1,4- oder 1,3-phenylen, 2,6-Dimethoxy-1,4-oder 1,3-phenylen, 2,6-Diäthoxy-1,4- oder 1,3-phenylen, 2-Methyl-6-methoxy-1,4- oder 1,3-phenylen, 2,6-Dibenzyl-1,4- oder 1,3-phenylen, 2,6-Dimethoxymethyl-1,4- oder 1,3-phenylen, 2,5,6-Trimethyl-1,4- oder 1,3-phenylen, 2,5,6-Triäthyl-1,4- oder 1,3-phenylen, 2,4,6-Trimethyl-1,3-phenylen, 2,3,5,6-Tetramethyl-1,4-phenylen, 2,4,5,6-Tetramethyl-1,3-phenylen, Tetrahydro-1,4-oder 1,3-naphthylen, Reste der Formeln

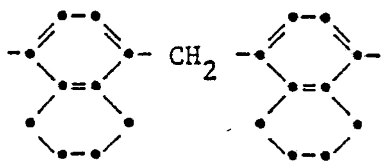 , 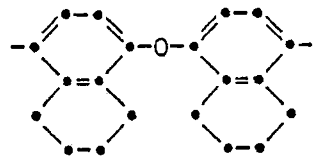 ,

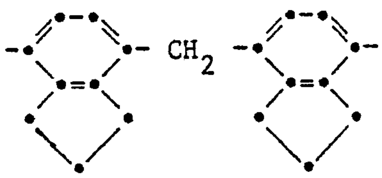 , 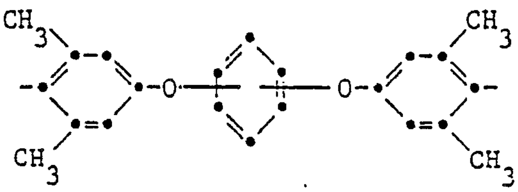

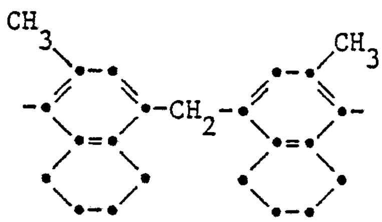 , 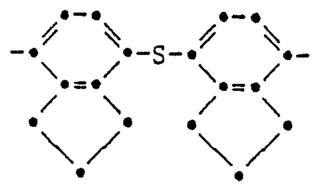 ,

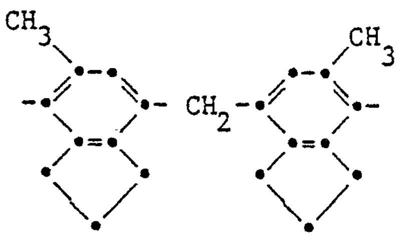 , 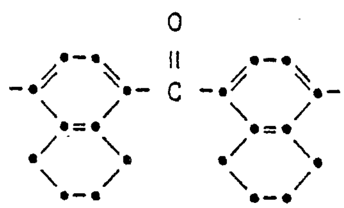 ,

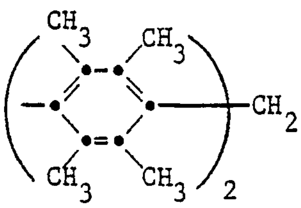, 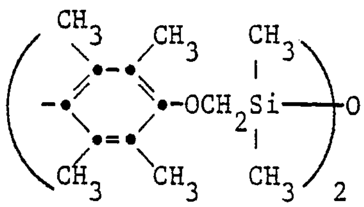, 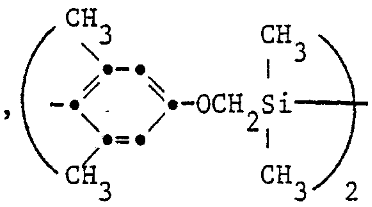 ,

sowie

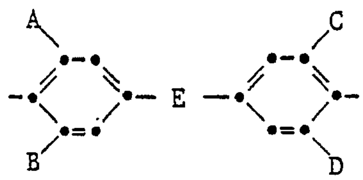 , 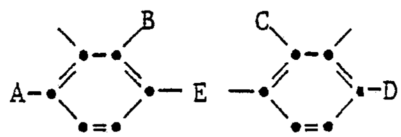

und 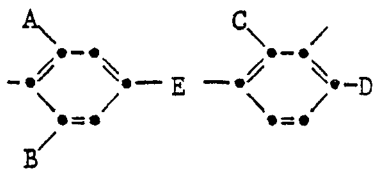

worin A, B, C, D und E die in nachfolgender Tabelle angegebenen Bedeutungen haben. Die freien Positionen in den Phenylkernen können hierbei durch einen oder zwei weitere Substituenten in jedem Kern besetzt sein, wobei diese Substituenten die in nachfolgender Tabelle für A, B, C oder D angegebene Bedeutung haben können.

| E | A | B | C | D |
|---|---|---|---|---|
| $CH_2$ | Methyl | Methyl | H | H |
| $CH_2$ | Methyl | Aethyl | H | H |
| $CH_2$ | Aethyl | Aethyl | H | H |
| $CH_2$ | Isopropyl | Isopropyl | H | H |
| $CH_2$ | Methoxymethyl | | H | H |
| $CH_2$ | Benzyl | Benzyl | H | H |
| $CH_2$ | Methyl | Methyl | Methyl | H |
| $CH_2$ | Aethyl | Aethyl | Aethyl | H |
| $CH_2$ | Isopropyl | Isopropyl | Methyl | Methyl |
| $CH_2$ | Methoxymethyl | | Methyl | H |
| $CH_2$ | Methyl | Aethyl | Methyl | H |
| $CH_2$ | Methoxymethyl | | Methoxymethyl | |
| $CH_2$ | Methyl | Methyl | Methyl | Methyl |
| $CH_2$ | Aethyl | Aethyl | Aethyl | Aethyl |
| $CH_2$ | Methyl | Methyl | Aethyl | Aethyl |
| $CH_2$ | Aethyl | Aethyl | Isopropyl | Isopropyl |
| $CH_2$ | Isopropyl | Isopropyl | Isopropyl | Isopropyl |
| $CH_2$ | Isopropyl | Isopropyl | Methyl | H |
| $CH_2$ | Methoxy | Methoxy | Methyl | Methyl |
| O | Methyl | Methyl | H | H |
| O | Aethyl | Aethyl | H | H |
| O | Methyl | Methyl | Methyl | H |
| O | Methyl | Methyl | Methyl | Methyl |
| O | Methyl | Methyl | Aethyl | Aethyl |
| S | Methyl | Methyl | H | H |

| E | A | B | C | D |
|---|---|---|---|---|
| S | Aethyl | Aethyl | H | H |
| S | Methyl | Methyl | H | H |
| S | Methyl | Methyl | Methyl | Methyl |
| S | Aethyl | Aethyl | Aethyl | Aethyl |
| S | Methyl | Methyl | Aethyl | Aethyl |
| CO | Methyl | Methyl | Methyl | H |
| CO | Methyl | Methyl | H | H |
| CO | Methyl | Methyl | Methyl | Methyl |
| $SO_2$ | Methyl | Methyl | Aethyl | H |
| $SO_2$ | Methyl | Methyl | H | H |
| $SO_2$ | Methyl | Methyl | Methyl | Methyl |
| $SO_2$ | Aethyl | Aethyl | Methyl | Methyl |
| SO | Methyl | Methyl | Methyl | Methyl |
| SO | Methyl | Methyl | H | H |
| COO | Methyl | Methyl | H | H |
| COO | Methyl | Methyl | Methyl | Methyl |
| $CONCH_3$ | Methyl | Methyl | H | H |
| $NCH_3$ | Methyl | Methyl | Aethyl | Aethyl |
| $NCH_3$ | Methyl | Methyl | Methyl | Methyl |
| CONH | Methyl | Methyl | - | - |
| NH | Aethyl | Methyl | Aethyl | Methyl |
| NH | Methyl | Methyl | Methyl | Methyl |

| E | A | B | C | D |
|---|---|---|---|---|
| $Si(Methyl)_2$ | Methyl | Methyl | H | H |
| $Si(Phenyl)_2$ | Methyl | Methyl | Methyl | Methyl |
| $Si(OMethyl)_2$ | Aethyl | Aethyl | H | H |
| $Si(OPhenyl)_2$ | Methyl | Methyl | Methyl | Methyl |
| $-OSi(Methyl)_2O-$ | Methyl | Methyl | Methyl | Methyl |
| Aethylen | Methyl | Methyl | H | H |
| Aethylen | Methyl | Methyl | Methyl | Methyl |
| Aethylen | Aethyl | Aethyl | H | H |
| Aethylen | Methyl | Methyl | Aethyl | Aethyl |
| Phenylen | Methyl | Methyl | Methyl | Methyl |
| Phenylen | Aethyl | Aethyl | H | H |
| $(CH_3)_2C<$ | Methyl | Aethyl | Methyl | Aethyl |
| $(CH_3)_2C<$ | Methyl | Methyl | Methyl | Methyl |
| $(CF_3)_2C<$ | Methyl | Methyl | Methyl | Methyl |
| direkte Bindung | Methyl | Methyl | H | H |
| direkte Bindung | Methyl | Aethyl | Methyl | Aethyl |
| direkte Bindung | Methyl | Aethyl | Methyl | H |
| direkte Bindung | Aethyl | Aethyl | Aethyl | Aethyl |
| direkte Bindung | Methoxy | Methoxy | Methoxy | Methoxy |
| direkte Bindung | Isopropyl | Isopropyl | H | H |
| direkte Bindung | Methoxymethyl | Methoxymethyl | Methoxymethyl | Methoxymethyl |

Die Diamine, von denen sich X ableitet, sind bekannt oder nach bekannten Verfahren herstellbar. Sihaltige Diamine sind in der US-PS 3, 435,002 und der EP-A-O 054 426 beschrieben. Diamine mit der

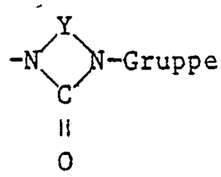

können aus den in der DE-A-2 318 170 beschriebenen Diisocyanaten hergestellt werden. Alkyl- oder Cycloalkyl substituierte, besonders Aethyl oder Propyl substituierte Diamine sind durch Alkylierungen von unsubstituierten oder teilsubstituierten aromatischen Diaminen mit Alkenen bzw. Cycloalkenen zugänglich (vgl. US-PS-3 275 690). Mehrkernige, besonders zweikernige aromatische Diamine sind über die Kondensation entsprechender Monoamine mit Aldehyden oder Ketonen erhältlich.

X′ im Strukturelement der Formel II kann lineares oder verzweigtes Alkylen mit 2 bis 30 C-Atomen, Cycloalkylen mit 5 bis 8 Ringkohlenstoffatomen, Aralkylen mit 7 bis 30 C-Atomen. Arylen mit 6 bis 22 C-Atomen und/oder ein Polysiloxanrest sein.

X′ in Formel II in der Bedeutung als zweiwertiger aliphatischer Rest enthält bevorzugt 6 bis 30 und insbesondere 6 bis 20 C-Atome. In einer bevorzugten Untergruppe ist X′ lineares oder verzweigtes Alkylen, das durch Sauerstoffatome, NH, $NR^a$, $^{\oplus}NR^a_2\ G^{\ominus}$ , Cyclohexylen, Naphthylen, Phenylen oder Hydantoinreste unterbrochen sein kann. $R^a$ kann z.B. Alkyl mit 1 bis 12 C-Atomen oder Cycloalkyl mit 5 oder 6 Ring-C-Atomen, Phenyl oder Benzyl sein. $G^{\ominus}$ bedeutet ein Anion einer Protonensäure, z.B. Halogenid, Sulfat, Phosphat. In einer bevorzugten Ausführungsform sind R bzw. R′ lineares oder verzweigtes Alkylen mit 6 bis 30 C-Atomen, $-(CH_2)_m-R^{13}-(CH_2)_n-$, worin $R^{13}$ Phenylen, Naphthylen, Cyclopentylen oder Cyclohexylen und m und n unabhängig voneinander die Zahl 1, 2 oder 3 sind, $-R^{14}(OR^{15})_p-O-R^{14}-$, worin $R^{14}$ Aethylen, 1,2-Propylen, 1,3-Propylen oder 2-Methyl-1,3-propylen und $R^{15}$ Aethylen, 1,2-Propylen, 1,2-Butylen, 1,3-Propylen oder 1,4-Butylen und p eine Zahl von 1 bis 100 sind, oder

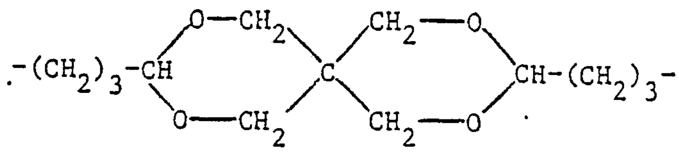

Beispiele für aliphatische Reste sind: Methylen, Aethylen, 1,2-oder 1,3-Propylen, 2,2-Dimethyl-1,3-propylen, 1,2-, 1,3- oder 1,4-Butylen, 1,3- oder 1,5-Pentylen, Hexylene, Heptylene, Octylene, Decylene, Dodecylene, Tetradecylene, Hexadecylene, Octadecylene, Eicosylene, 2,4,4-Trimethylhexylen, 1,10-Dialkyldecylen, wobei das Alkyl bevorzugt 1- bis 6-C-Atome aufweist, substituierte 1,11-Undecylene, wie sie z.B. in der EP-B-O 011 559 beschrieben sind, Reste von Jeffaminen wie z.B.

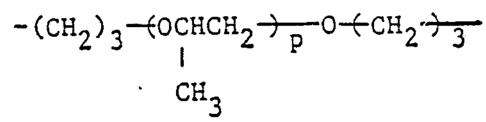

mit p = 1 bis 100 oder
$-(CH_2)_3-(O(CH_2)_4)_p-O-(CH_2)_3-$ mit p = 1-100, Dimethylencyclohexan, Xylylen und Diäthylenbenzol.

Bei den durch heterocyclische Reste unterbrochenen aliphatischen Resten kann es sich z.B. um solche handeln, die sich von N,N′-aminoalkylierten Hydantoinen oder Benzimidazolen ableiten. Beispiele sind N,N′-(γ-Aminopropyl)-5,5-dimethyl-hydantoin oder -benzimidazolon und solche der Formel

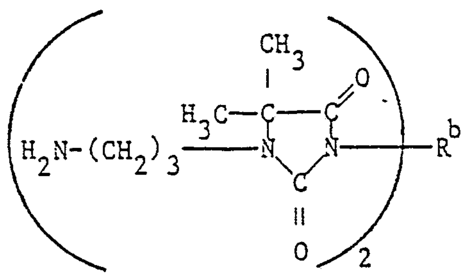

,

worin $R^b$ Alkylen mit 1 bis 12, bevorzugt 1 bis 4 C-Atomen oder

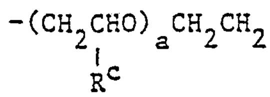

ist, worin $R^c$ ein Wasserstoffatom oder Methyl und a ganze Zahlen von 1-20 bedeuten.

Geeignete Substituenten für die aliphatischen Reste sind z.B. Hydroxy, Halogenid wie F oder Cl oder Alkoxy mit 1 bis 6 C-Atomen.

X' in Formel I in seiner Bedeutung als zweiwertiger cycloaliphatischer Rest enthält bevorzugt 5 bis 8 Ring-C-Atome und ist besonders unsubstituiertes, oder mit Alkyl, das vorzugsweise 1 bis 3 C-Atome enthält, substituiertes ein- oder zweikerniges Cycloalkylen mit 5 bis 7 Ring-C-Atomen. In einer bevorzugten Ausführungsform ist X' als cycloaliphatischer Rest ein solcher der Formeln

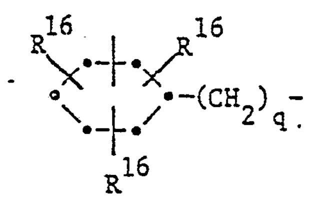

oder

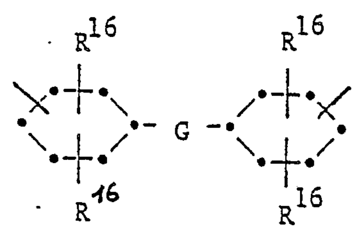

,

worin q 0 oder 1 ist, die $R^{16}$ unabhängig Wasserstoff oder Alkyl mit 1 bis 6 C-Atomen bedeuten und G für eine direkte Bindung O, S, $SO_2$, Alkylen mit 1 bis 3 C-Atomen oder Alkyliden mit 2 bis 6 C-Atomen steht. $R^{16}$ ist bevorzugt Aethyl und Methyl, G bevorzugt Methylen und das Alkyliden enthält bevorzugt 2 oder 3 C-Atome, wie Aethyliden und 1,1- oder 2,2-Propyliden.

Beispiele für X' als Cycloalkylen sind: 1,2- oder 1,3-Cyclopentylen, 1,2-, 1,3- oder 1,4-Cyclohexylen, Cycloheptylen, Cyclooctylen, Methylcyclopentylen, Methyl- oder Dimethylcyclohexylen, 3'- oder 4'-Methylcyclohex-1-yl, 5-Methyl-3-methylencyclo hex-1-yl, 3,3'- oder 4,4'-Bis-cyclohexylen, 3,3'-Dimethyl-4,4'-biscyclohexylen, 4,4'-Biscyclohexylenäther oder -sulfon oder -methan oder -2,2-propan, sowie die Reste von Bis-aminomethyltricyclodecan, Bis-aminomethylnorbornan und Menthandiamin.

Besonders bevorzugt ist X' als cycloaliphatischer Rest 1,4- oder 1,3-Cyclohexylen, 3,5,5-Trimethylcyclohex-1-yl-3-meth-1-yl, Methylenbis(cyclohex-4-yl) oder Methylenbis(3-methylcyclohex-4-yl).

X' als araliphatischer Rest enthält bevorzugt 7 bis 30 C-Atome. Die aromatischen Gruppen sind bevorzugt so substituiert wie X' als aromatischer Rest, einschliesslich der Bevorzugungen, zumindest aber monosubstituiert, bevorzugt in Orthostellung zum N-Atom. Der araliphatische Rest enthält besonders 8 bis 26 C-Atome. Der aromatische Rest im araliphatischen Rest ist bevorzugt ein Phenylrest. In seiner Bedeutung als araliphatischer Rest ist X' besonders unsubstituiertes oder am Aryl durch Alkyl substituiertes Aralkylen, wobei der Alkylenrest linear oder verzweigt ist. In einer bevorzugten Ausführungsform entspricht der araliphatische Rest der Formel

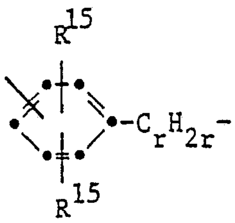

worin die $R^{15}$ unabhängig voneinander ein Wasserstoffatom oder besonders Alkyl mit 1-6 C-Atomen und r ganze Zahlen von 1-20 bedeuten.

Die freie Bindung befindet sich bevorzugt in m-Stellung oder p-Stellung zur $C_rH_{2r}$-Gruppe und eine oder beide $R^{15}$ sind bevorzugt in o-Stellung zur freien Bindung gebunden.

Beispiele für X′ als araliphatischer Rest sind: m- oder p-Benzylen, 3-Methyl-p-benzylen, 3-Aethyl-p-Benzylen, 3,5-Dimethyl-p-benzylen, 3,5-Diäthyl-p-benzylen, 3-Methyl-5-äthyl-p-benzylen, p-Phenylenpropylen, 3-Methyl-p-phenylen-propylen, p-Phenylenbutylen, 3-Aethyl-p-phenylenpentylen sowie insbesondere längerkettige Phenylenalkylenreste, die z.B. in der EP-A-O 069 062 beschrieben sind: 6-(p-Phenylen)-6-methylhept-2-yl, 6-(3′-Methyl-p-phenylen)-6-methylhept-2-yl, 6-(3′-Aethyl-p-phenylen)-6-methylhept-2-yl, 6-(3′,5′—Dimethyl-p-phenylen)-6-methylhept-2-yl, 11-(p-Phenylen)-2,11-dimethyl-dodec-1-yl, 12-(p-Phenylen)-2,12-dimethyltetradec-3-yl.

X′ als Arylen enthält bevorzugt 6 bis 22 C-Atome. Das Arylen ist besonders ein ein- oder zweikerniger Phenylenrest. Das Arylen kann substituiert sein, z.B. durch Alkyl oder Alkoxy mit 1 bis 6 C-Atomen, Alkoxymethyl mit 2 bis 6 C-Atomen und/oder Halogen wie F oder Cl. Bevorzugt sind substituierte aromatische Reste, da solche Copolyimide im allgemeinen löslicher sind. Ferner sind 1,3-Phenylene bevorzugt, die in einer Orthostellung zur freien Bindung durch Alkyl mit 1 bis 4 C-Atomen, besonders Methyl, substituiert sind.

In einer Ausführungsform entspricht X′ der Formel IV,

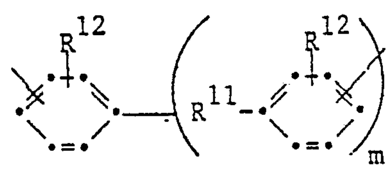 (IV)

worin m 0 oder 1 ist, die freien Bindungen in Meta- und bevorzugt in Orthostellung zur $R^{12}$-Gruppe gebunden sind, $R^{11}$ die gleiche Bedeutung wie in Formel IIIa hat und $R^{12}$ die gleiche Bedeutung wie $R^5$ hat.

Eine bevorzugte Untergruppe sind Arylenreste der Formeln IVa, oder IVb oder IVc

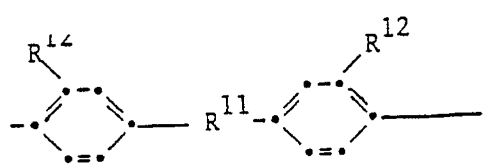 (IVa) , 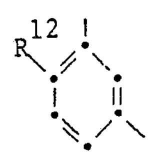 (IVb) ,

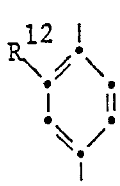 (IVc) ,

worin $R^{11}$ für eine direkte Bindung, -O-, -CO- oder $-CH_2-$ steht und $R^{12}$ Methyl, Aethyl, Isopropyl, Methoxy, Aethoxy oder ein Wasserstoffatom bedeutet.

Beispiele für Diamine $H_2N-X'-NH_2$ mit einem aromatischen Rest sind:

4,4′-Methylenbis-(o-chloranilin), 3,3′-Dichlorbenzidin, 3,3′-Sulfonyldianilin, 4,4′-Diaminobenzophenon, 1,5-Diaminonaphthalin, Bis-(4-aminophenyl)-dimethylsilan, Bis-(4-aminophenyl)-diäthylsilan, Bis-(4-aminophenyl)-diphenylsilan, Bis-(4-aminophenyloxy)-dimethylsilan, Bis-(4-aminophenyl)-äthylphosphinoxid, N-[Bis-(4-aminophenyl]-N-methylamin, N-[Bis-(4-aminophenyl]-N-phenylamin, 4,4'-Methylenbis-(3-methylanilin, 4,4'-Methylenbis-(2-äthylanilin), 4,4'-Methylenbis-(2-methoxyanilin), 5,5'-Methylenbis-(2-aminophenol), 4,4'-Methylenbis-(2-methylanilin), 4,4'-Oxybis-(2-methoxyanilin), 4,4'-Oxybis-)2-chloranilin), 5,5'-Oxybis-(2-aminophenol), 4,4'-Thiobis-(2-methylanilin),4,4'-Thiobis-(2-methoxyanilin), 4,4'-Thiobis-(2-chloranilin),4,4'-Sulfonylbis-(2-methylanilin, 4,4'-Sulfonylbis-(2-äthoxyanilin), 4,4'-Sulfonylbis-(2-chloranilin), 5,5'-Sulfonylbis-(2-aminophenol), 3,3'-Dimethyl-4,4'-diaminobenzophenon, 3,3'-Dimethoxy-4,4'-diaminobenzophenon, 3,3'-Dichlor-4,4'-diaminobenzophenon, 4,4'-Diaminobiphenyl, n-Phenylendiamin, p-Phenylendiamin, 4,4'-Methylendianilin, 4,4'-Oxydianilin, 4,4'-Thiodianilin, 4,4'-Sulfonyldianilin, 4,4'-Isopropylidendianilin, 3,3'-Dimethylbenzidin, 3,3'-Di-methoxybenzidin, 3,3'-Dicarboxybenzidin, Diaminotoluol, 4,4'-Methylen-bis-(3-carboxyanilin) und deren Ester, 5-Amino-1-(4-aminophenyl)-1,3,3-Trimethylindan.

X' kann auch ein Siloxangruppen enthaltender zweiwertiger Rest sein. Dieser kann der Formel

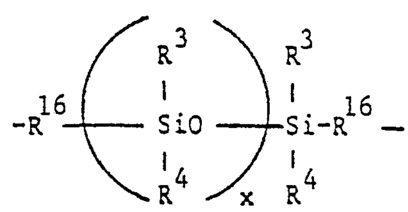

entsprechen, worin X für eine rationale Zahl von mindestens 1 steht, $R^3$ und $R^4$ die zuvor angegebene Bedeutung haben und $R^{16}$ ein zweiwertiger Kohlenwasserstoffrest ist, z.B. Alkylen mit 1 bis 12, vorzugsweise 1 bis 6 C-Atomen, Cycloalkylen mit bevorzugt 5 oder 6 Ringkohlenstoffatomen oder Phenylen. $R^3$ und $R^4$ sind bevorzugt Methyl oder Phenyl und X bevorzugt eine Zahl von 1 bis 1000, besonders 1 bis 100 und insbesondere 1-10. Beispiele für Alkylen sind Aethylen, 1,3- oder 1,2-Propylen, 1,3- oder 1,4-Butylen. Diamine mit dieser Gruppe X' sind in der US-PS 4 030 948 beschrieben. Weitere geeignete Diamine mit einer Siloxangruppen enthaltenden Gruppe X' sind in der US-PS 3 435 002 und EP-A-O 054 426 beschrieben.

Es ist bekannt, dass einige aliphatische und aromatische Diamine, z.B. Phenylendiamin oder Di-(aminophenyl)methan, die Unlöslichkeit von Polyimiden fördern können. Solche Diamine werden daher bevorzugt in geringeren Mengen eingesetzt. Insbesondere sind für diesen Fall die Strukturelemente der Formel I zu mindestens 50 Mol.-%, besonders 80 :Mol-% und ganz besonders 90 Mol-% enthalten.

Z und Z' enthalten als zweiwertiger aromatischer Rest bevorzugt 6 bis 30, besonders 6 bis 20 C-Atome. In einer bevorzugten Untergruppe entsprechen Z und Z' den Formeln

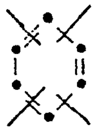 , 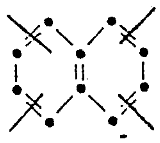 ,

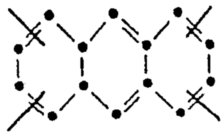 , 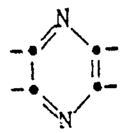 , 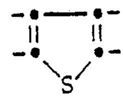

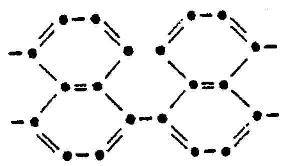 , 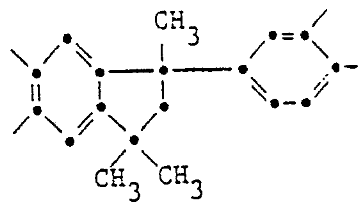

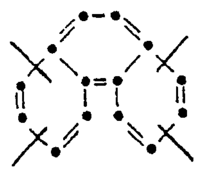 , 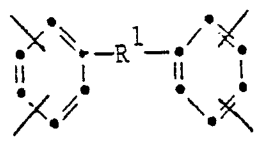

worin $R^1$ eine direkte Bindung oder eine Brückengruppe der Formeln

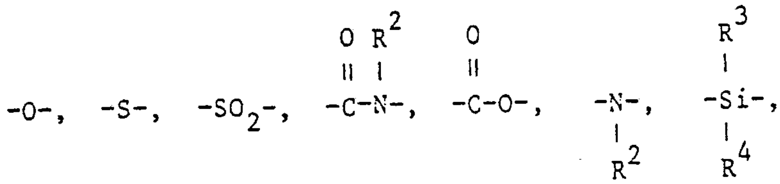

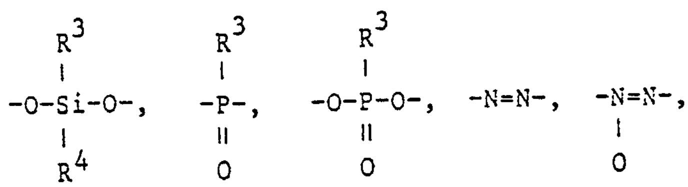

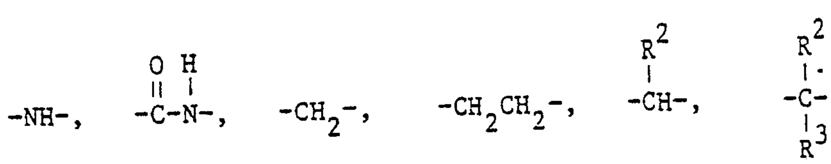

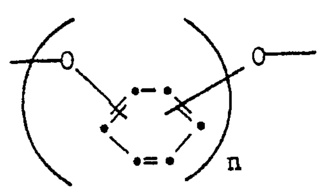 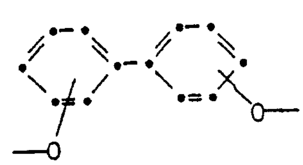

ist, worin $R^2$, $R^3$ und $R^4$ Alkyl mit 1 bis 6 C-Atomen, Phenyl oder Benzyl und $R^3$ und $R^4$ Alkoxy mit 1 bis 6 C-Atomen, Phenyloxy oder Benzyloxy sind.

In den vorausstehenden Formeln befinden sich stets je zwei der freien Bindungen in Peri- und/oder Orthostellung.

Eine bevorzugte Untergruppe für Z und Z' sind Reste der Formeln

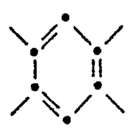

oder

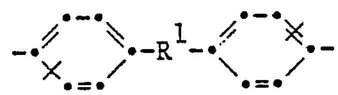

ist, worin $R^1$ eine direkte Bindung, -O-, $-SO_2-$ oder $-CH_2-$ ist.

Ganz besonders bevorzugt ist der Rest der Formel

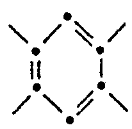

.

Beispiele für Tetracarbonsäureanhydride mit einem Rest Z bzw. Z' sind:
2,3,9,10-Perylentetracarbonsäuredianhydrid,
1,4,5,8-Naphthalintetracarbonsäuredianhydrid,
2,6-Dichlornaphthalin-1,4,5,8-tetracarbonsäuredianhydrid,
2,7-Dichlornaphthalin-1,4,5,8-tetracarbonsäuredianhydrid,
2,3,6,7-Tetrachlornaphthalin-1,4,5,8-tetracarbonsäuredianhydrid,
Phenanthren-1,8,9,10-tetracarbonsäuredianhydrid,
Pyromellitsäuredianhydrid,
3,3',4,4'-Biphenyltetracarbonsäuredianhydrid,
2,2',3,3'-Biphenyltetracarbonsäuredianhydrid,
4,4'-Isopropylidendiphthalsäureanhydrid,
3,3'-Isopropylidendiphthalsäureanhydrid,
4,4'-Oxydiphthalsäureanhydrid,
4,4'-Sulfonyldiphthalsäureanhydrid,
3,3'-Oxydiphthalsäureanhydrid,
4,4'-Methylendiphthalsäureanhydrid,
4,4'-Thiodiphthalsäureanhydrid,
4,4'-Aethylidendiphthalsäureanhydrid,
2,3,6,7-Naphthalintetracarbonsäuredianhydrid,
1,2,4,5-Naphthalintetracarbonsäuredianhydrid,
1,2,5,6-Naphthalintetracarbonsäuredianhydrid,
Benzol-1,2,3,4-tetracarbonsäuredianhydrid,
Thiophen-2,3,4,5-tetracarbonsäuredianhydrid,
1-(3',4'-Dicarboxyphenyl)-1,3,3-trimethylindan-5,6-dicarbonsäuredianhydrid,
1-(3',4'-Dicarboxyphenyl)-1,3,3-trimethylindan-6,7-dicarbonsäuredianhydrid,
1-(3',4'-Dicarboxyphenyl)-3-methylindan-5,6-dicarbonsäuredianhydrid,
1-(',4'-Dicarboxyphenyl)-3-methylindan-6,7-dicarbonsäuredianhydrid.

Die erfindungsgemässen Polyimide weisen mittlere Molekulargewichte (Gewichtsmittel Mw) von mindestens 2 000, vorzugsweise mindestens 5 000 auf. Die obere Grenze richtet sich im wesentlichen nach Eigenschaften, die die Verarbeitbarkeit bestimmen, wie z.B. deren Löslichkeit. Sie kann bis zu 500 000, vorzugsweise bis zu 100 000 und besonders bis zu 60 000 betragen. Es kann sich ferner um statistische Polyimide oder um Blockpolyimide handeln. Sie werden nach üblichen Verfahren in hierfür vorgesehenen Einrichtungen hergestellt.

Ein weiterer Gegenstand vorliegender Erfindung ist ein Verfahren zur Herstellung von Polyimiden mit Strukturelementen der Formel I und/oder II, das dadurch gekennzeichnet ist, dass man mindestens 5 Mol %, bezogen auf die Tetracarbonsäuren, eine Tetracarbonsäure der Formel V

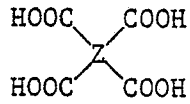

(V)

alleine oder zusammen mit mindestens einer Tetracarbonsäure der Formel Va, oder deren polyimidbildenden Derivate,

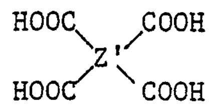

(Va)

mit mindestens 5 Mol-%, bezogen auf die Diamine, mindestens eines Diamines der Formel VI
$H_2N\text{-}X\text{-}NH_2$ (VI)
alleine oder zusammen mit höchstens 95 Mol-% mindestens eines Diamines der Formel VIa
$H_2N\text{-}X'\text{-}NH_2$ (VIa)
in an sich bekannter Weise polykondensiert und anschliessend cyclisiert, sowie die nach diesem Verfahren erhältlichen Polyimide. Anstelle der Tetracarbonsäuren können auch deren polyimidbildende Derivate verwendet werden, wie z.B. deren Ester, Amide, Halogenide, besonders die Chloride, und Anhydride.

Die Ausgangsverbindungen sind bekannt, käuflich erhältlich oder nach bekannten Verfahren herstellbar. Die Reaktion wird vorteilhaft in Lösung durchgeführt; geeignete inerte Lösungsmittel sind nachfolgend genannt. Die Reaktionstemperaturen können -20 bis 300 °C betragen.

Im einzelnen geht man zweckmässig so vor, dass man Tetracarbonsäuredianhydrid und Diamin zunächst unter Bildung einer Polyamidsäurevorstufe umsetzt und diese Polyamidsäure anschliessend unter Wasserabspaltung cyclisiert. Die Cyclisierung kann thermisch erfolgen. Vorteilhaft wird die Cyclisierung unter Einwirkung von wasserentziehenden Mitteln, z.B. Carbonsäureanhydriden wie Acetanhydrid, vorgenommen. Die Polyimide können anschliessend nach üblichen Verfahren, z.B. durch Entfernen des Lösungsmittels oder Ausfällen durch Zugabe eines Nichtlösungsmittels, isoliert werden.

Eine weitere Herstellungsmethode besteht darin, dass man das Tetracarbonsäuredianhydrid mit einem Diisocyanat in einer Stufe zum Polyimid umsetzt.

Die erfindungsgemässen Polyimide sind in unterschiedlichen Lösungsmitteln löslich, gegebenenfalls unter Erwärmen, und sie weisen erhöhte Glasumwandlungstemperaturen auf, die bis über 500 °C betragen können. Sie eignen sich hervorragend zur Herstellung von Filmen und Schutzüberzügen, wobei Beschichtungsmittel aus einer Lösung des Polyimides in einem Lösungsmittel Anwendung finden können. Ein weiterer Gegenstand vorliegender Erfindung ist ein solches Beschichtungsmittel und die Verwendung der erfindungsgemässen Polyimide zur Herstellung von Schutzüberzügen und Filmen.

Zur Herstellung des erfindungsgemässen beschichteten Materials löst man das Polymer oder Gemische davon zweckmässig in einem geeigneten organischen Lösungsmittel, gegebenenfalls unter Erwärmung. Geeignete Lösungsmittel sind z.B. polare, aprotische Lösungsmittel, die alleine oder in Mischungen aus mindestens zwei Lösungsmitteln verwendet werden können. Beispiele sind: Aether wie Dibutyläther, Tetrahydrofuran, Dioxan, Methylenglykol, Dimethyläthylenglykol, Dimethyldiäthylenglykol, Diäthyldiäthylenglykol, Dimethyltriäthylenglykol, halogenierte Kohlenwasserstoffe wie Methylenchlorid, Chloroform, 1,2-Dichloräthan, 1,1,1-Trichloräthan, 1,1,2,2-Tetrachloräthan, Carbonsäureester und Lactone wie Essigäureäthylester, Propionsäure methylester, Benzoesäureäthylester, 2-Methoxyäthylacetat, γ-Butyrolacton, o-Valerolacten und Pivalolacton, Carbonsäureamide und Lactame wie Formamid, Acetamid, N-Methylformamid, N-N-Dimethylformamid, N,N-Diäthylformamid, N,N-Dimethylacetamid, N,N-Diäthylacetamid, γ-Butyrolactam, ε-Caprolactam, N-Methypyrrolidon, N-Acetylpyrrolidon, N-Methylcaprolactam, Tetramethylharnstoff, Hexamethylphosphorsäureamid, Sulfoxide wie Dimethylsulfoxid, Sulfone wie Dimethylsulfon, Diäthylsulfon, Trimethylensulfon, Tetramethylensulfon, Trimethylamin, Triäthylamin, N-Methylpyrrolidin, N-Methylpiperidin, N-Methylmorpholin, substituierte Benzole wie Chlorbenzol, Nitrobenzol, Phenole oder Kresole.

Ungelöste Anteile können durch Filtration, bevorzugt einer Druckfiltration entfernt werden. Die Konzentration an Polymer im so erhaltenen Beschichtungsmittel beträgt vorzugsweise nicht mehr als 50 Gew.-%, besonders nicht mehr als 30 Gew.-% und insbesondere nicht mehr als 20 Gew.-%, bezogen auf die Lösung.

Bei der Herstellung der Lösungen können weitere übliche Zusatzstoffe einverleibt werden, die die Lichtempfindlichkeit nicht negativ beeinflussen. Beispiele hierfür sind Mattierungsmittel, Verlaufmittel, feinteilige Füllstoffe, Flammschutzmittel, optische Aufheller, Antioxidantien, Lichtschutzmittel, Stabilisatoren,

Farbstoffe, Pigmente Haftvermittler und Antihalofarbstoffe, wie sie z.B. in der US-PS 4 349 619 beschrieben sind.

Das Beschichtungsmittel kann mittels üblichen Methoden wie Tauch-, Streich- und Sprühverfahren, Schleuder-, Kaskadenguss- und Vorhanggussbeschichtung, auf geeignete Substrate bzw. Trägermaterialien, aufgebracht werden. Geeignete Substrate sind z.B. Kunststoffe, Metalle und Metallegierungen, Halbmetalle, Halbleiter, Glas, Keramik und andere anorganische Materialien wie z.B. $SiO_2$ und $Si_3N_4$. Danach wird das Lösungsmittel gegebenenfalls durch Erwärmen und gegebenenfalls im Vakuum entfernt. Man erhält klebfreie, trockene und gleichmässige Filme. Die aufgebrachten. Filme können je nach Anwendung Schichtdicken bis zu ca. 500 µm und mehr, bevorzugt von 0,5 bis 500 µm und besonders von 1 bis 50 µm aufweisen.

Die nachfolgenden Beispiele erläutern die Erfindung näher.

## A) Herstellungsbeispiele

### Beispiele 1-7:

In einem zylindrischen Gefäss, das mit Rührer, Tropftrichter, Innenthermometer und Stickstoffeinleitungsrohr ausgestattet ist, werden unter Stickstoff 0,04 Mol der in Tabelle 1 aufgeführten Diamine in 130 ml N-Methylpyrrolidon (NMP) gelöst und auf 0 bis 5 °C abgekühlt. Nun werden 0,04 Mol Pyromellitsäuredianhydrid bereitgestellt und in Portionen im Verlaufe von 4 Stunden zugesetzt. 30 Minuten nach dem letzten Zusatz werden 8,9 g Triäthylamin (0,09 Mol) und 36.7 g (0.36 Mol) Acetanhydrid zugetropft, um die entstandene Polyamidsäure zum Polyimid zu cyclisieren. Nach 16 Stunden Rühren bei Raumtemperatur wird die Lösung unter starkem Rühren auf 2 l Wasser gegossen und das ausgefallene Produkt abfiltriert. Das Produkt wird erneut mit 2 l Wasser behandelt, filtriert und bei 80 °C im Vakuum getrocknet. Die Inhärente Viskosität, gemessen als 0,5 %ige Lösung in NMP bei 25 °C und die Glasumwandlungstemperatur (Tg), gemessen durch Differential-Scanning-Calometrie (DSC) sind in Tabelle 1 aufgeführt.

### Beispiele 8 und 9:

Gemäss Beispiel 1 werden Diamine mit einer äquivalenten Menge 4,4′-Methylendiphthalsäureanhydrid umgesetzt und anschliessend zum Polyimid cyclisiert. Die Diamine und die Eigenschaften der Polyimide sind in Tabelle 1 zusammengefasst.

Tabelle 1

| Beispiel | Diamin | $\eta$ inh. (dl/g) | Tg (°C) |
|---|---|---|---|
| 1 | 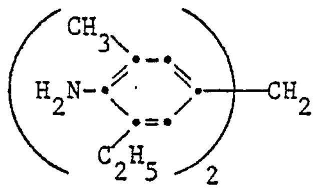 (50 Mol-%)<br>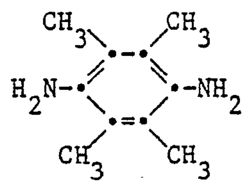 (25 Mol-%)<br>2,4-Toluoldiamin (25 Mol-%) | 0,75 | 437 |
| 2 | 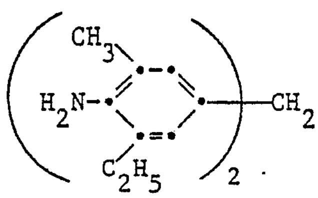 (60 Mol-%)<br>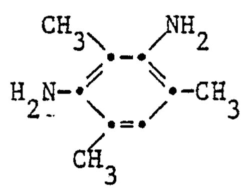 (40 Mol-%) | 0,83 | 513 |
| 3 | 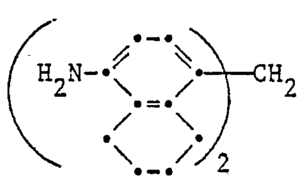 | - [1)] | 375 |

Tabelle 1 (Fortsetzung)

| Beispiel | Diamin | η inh.(dl/g) | Tg (°C) |
| --- | --- | --- | --- |
| 4 | wie Beispiel 3 (70 Mol-%)<br>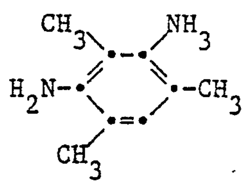 (30 Mol-%) | 1,002 | 423 |
| 5 | wie Beispiel 1 (40 Mol-%)<br>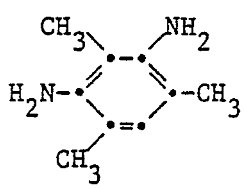 (30 Mol-%)<br>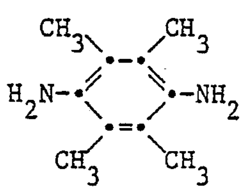 (30 Mol-%) | - 1) | 494 |
| 6 | wie Beispiel 3 (70 Mol-%)<br>2,4-Toluoldiamin (30 Mol-%) | 0,868 | 425 |
| 7 | 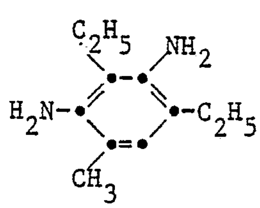 | 0,576 | >500 |
| 8 | 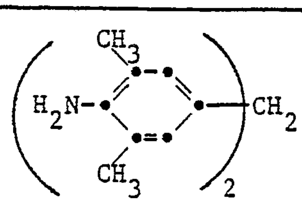 | 0,352 | 281 |

Tabelle 1 (Fortsetzung)

| Beispiel | Diamin | η inh.(dl/g) | Tg (°C) |
|---|---|---|---|
| 9 | wie Beispiel 3 | 0,596 | 319 |

* Schmelzbereich 490°C

1) nicht bestimmt.

**Ansprüche**

1. Lösliche Homo- und Copolyimide aus mindestens einer aromatischen Tetracarbonsäure und mindestens einem aromatischen Diamin, die im wesentlichen aus 5 bis 100 Mol-% mindestens eines Strukturelements der Formel I

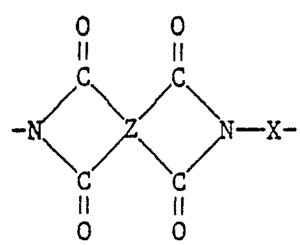

(I)

und 95-0 Mol-% mindestens eines Strukturelementes der Formel II

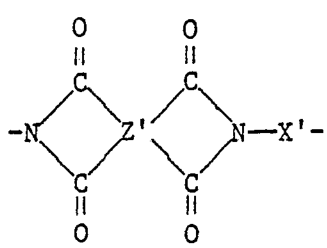

(II),

bestehen, worin
Z einen unsubstituierten oder substituierten vierwertigen aromatischen Rest mit Ausnahme eines Restes der Benzophenontetracarbonsäure darstellt, an den je zwei Carbonylgruppen in Ortho- oder Peristellung gebunden sind,
X den zweiwertigen Rest eines aromatischen Diamines bedeutet,
Z′ die gleiche Bedeutung wie Z hat, oder ein von Z verschiedener vierwertiger aromatischer Rest mit Ausnahme eines Restes der Benzophenontetracarbonsäure ist, und
X′ der zweiwertige, von X verschiedene Rest eines organischen Diamines ist, dadurch gekennzeichnet, dass der aromatische Rest von X in beiden Orthostellungen zu mindestens einem N-Atom durch Alkyl,

Cycloalkyl, Alkoxy, Alkoxyalkyl, oder Aralkyl substituiert ist, oder dass zwei benachbarte C-Atome des aromatischen Restes durch Alkylen substituiert sind.

2. Polyimide gemäss Anspruch 1, dadurch gekennzeichnet, dass X als aromatischer Rest einen zweiwertigen, ein- oder zweikernigen Phenylenrest darstellt.

3. Polyimide gemäss Anspruch 1, dadurch gekennzeichnet, dass der Substituent von X als Alkyl oder Alkoxy 1 bis 20 C-Atome, als Alkoxyalkyl 2 bis 12 C-Atome, als Cycloalkyl 5 oder 6 Ringkohlenstoffatome und als Alkylen 3 oder 4 C-Atome enthält und als Aralkyl Benzyl ist.

4. Polyimide gemäss Anspruch 3, dadurch gekennzeichnet, dass der Substituent Alkyl mit 1 bis 4 C-Atomen, bevorzugt Isopropyl, Aethyl und besonders Methyl ist.

5. Polyimide gemäss Anspruch 1, dadurch gekennzeichnet, dass Z und Z′ als aromatischer Rest 6 bis 30 C-Atome enthält.

6. Polyimide gemäss Anspruch 1, dadurch gekennzeichnet, dass Z und Z′ Reste der Formeln

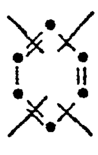 , 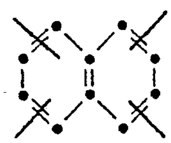 ,

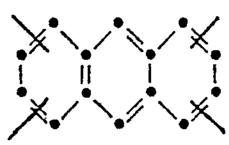 , 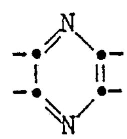 , 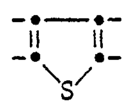

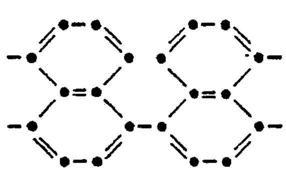 , 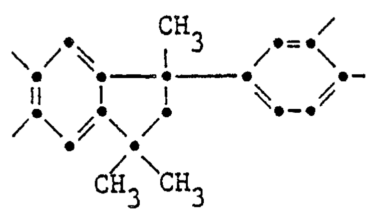

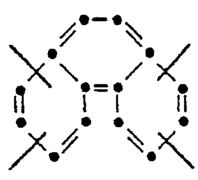 , 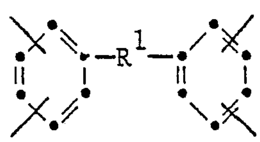

sind,
worin R¹ eine direkte Bindung oder eine Brückengruppe der Formeln

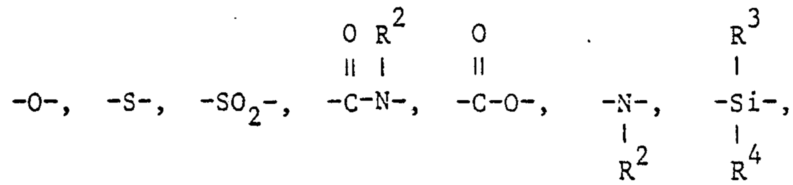

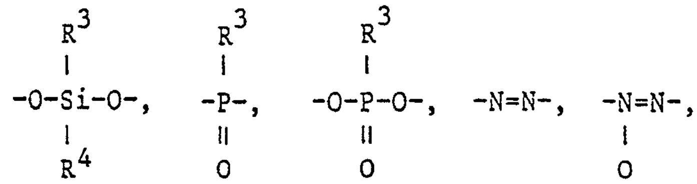

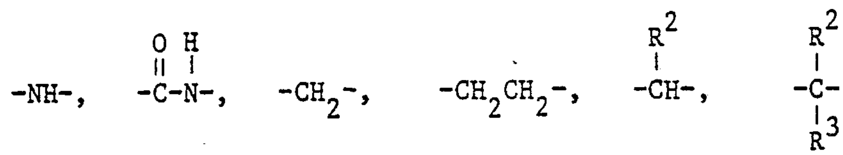

sind, worin $R^2$, $R^3$ und $R^4$ Alkyl mit 1 bis 6 C-Atomen, Phenyl oder benzyl und $R^3$ und $R^4$ auch Alkoxy mit 1 bis 6 C-Atomen, Phenyloxy oder Benzyloxy sind.

7. Polyimide gemäss Anspruch 6, dadurch gekennzeichnet, dass Z und Z′ ein Rest der Formeln

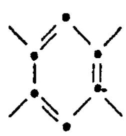 oder 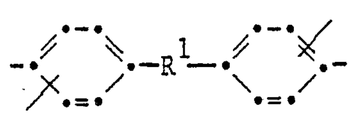

sind, worin $R^1$ eine direkte Bindung, -O-, $-SO_2-$, oder $-CH_2-$ ist.

8. Polyimide gemäss Anspruch 7, dadurch gekennzeichnet, dass Z und Z′ ein Rest der Formel

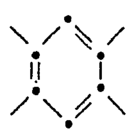

ist.

9. Polyimide gemäss Anspurch 1, dadurch gekennzeichnet, dass X als aromatischer Rest den Formeln III, IIIa und/oder IIIb entspricht,

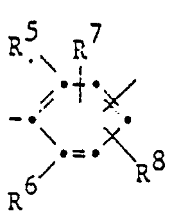 (III) 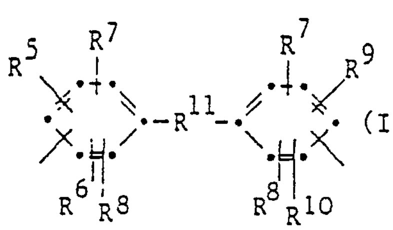 (IIIa) 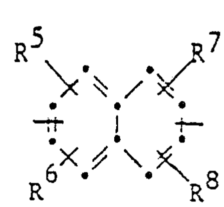 (IIIb)

worin in Formel III die freien Bindungen in Meta- oder Parastellung zueinander stehen, in Formel IIIa die freien Bindungen bevorzugt in Meta- oder Parastellung zur $R^{11}$-Gruppe stehen und $R^5$ und $R^6$ in den beiden Orthostellungen der freien Bindung gebunden sind, und in Formel IIIb die freien Bindungen in 2-, 3-, 6- und 7-Stellung gebunden sind und $R^5$ und $R^6$ sich in den beiden Orthostellungen der freien Bindungen befinden, $R^{11}$ für eine direkte Bindung, -O-, -S-, -SS-, -SO-, $-SO_2-$, -CO-, -COO-, -NH-, -N-Alkyl mit 1 bis 6 C-Atomen im Alkyl, - N̍ -Phenyl, - N̍ -Benzyl, -CONH-, -CON-Alkyl- mit 1 bis 6 C-Atomen im Alkyl, -CON-

Phenyl-, -CON-Benzyl-,

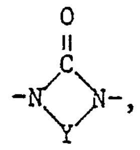 worin Y für 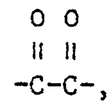, 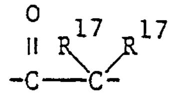 oder 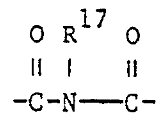 steht und

$R^{17}$ ein Wasserstoffatom, $C_1$-$C_6$-Alkyl oder Phenyl bedeutet, lineares oder verzweigtes Alkylen mit 1 bis 3 C-Atomen, gegebenenfalls durch Cl oder F substituiertes Alkyliden mit 2 bis 12 C-Atomen, Cycloalkyliden mit 5 oder 6 Ringkohlenstoffatomen, Phenylen, Phenylendioxy oder die Gruppe

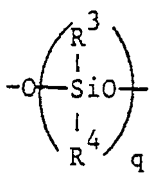 oder 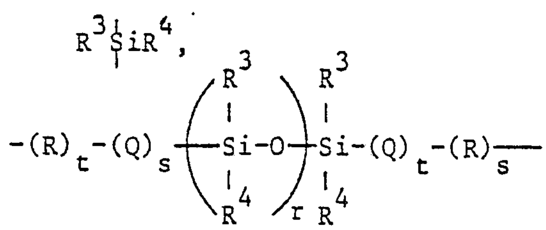 steht, worin $R^3$

und $R^4$ Alkyl oder Alkoxy mit 1 bis 6 C-Atomen, Phenyl, Benzyl, Phenyloxy oder Benzyloxy sind, r eine Zahl von 1 bis 10, t 0 oder 1 und S 0 oder 1 ist, und R -O- oder -S- und Q $C_1$-$C_6$-Alkylen bedeuten, und q für eine Zahl von 1 bis 100 steht, $R^5$ und $R^6$ Alkyl oder Alkoxy, mit 1 bis 12 C-Atomen, Alkoxyalkyl mit 2 bis 12 C-Atomen Cyclopentyl, Cyclohexyl oder Benzyl sind oder in den Formeln III oder IIIa $R^5$ und $R^7$ in Nachbarstellung gebunden sind und zusammen Trimethylen oder Tetramethylen bedeuten, wobei $R^6$ auch ein Wasserstoffatom sein kann, $R^7$ und $R^8$ ein Wasserstoffatom sind oder unabhängig die Bedeutung von $R^5$ und $R^6$ haben, und $R^9$ und $R^{10}$ ein Wasserstoffatom sind, unabhängig die Bedeutung von $R^5$ und $R^6$ haben oder $R^7$ und $R^9$ in Formel IIIa zusammen Trimethylen oder Tetramethylen sind.

10. Polyimide gemäss Anspruch 9, dadurch gekennzeichnet, dass $R^5$ und $R^6$ Alkyl mit 1 bis 6 C-Atomen, besonders Methyl, Aethyl n-Propyl oder Isopropyl sind.

11. Polyimide gemäss Anspruch 9, dadurch gekennzeichnet, dass $R^{11}$ $-CH_2-$, -O-, -CO- oder eine direkte Bindung darstellt.

12. Polyimide gemäss Anspruch 9, dadurch gekennzeichnet, dass in Formel IIIa die freien Bindungen in Parastellung zur $R^{11}$-Gruppe stehen.

13. Polyimide gemäss Anspruch 1, dadurch gekennzeichnet, dass sie mindestens 2, bevorzugt 2 bis 4 verschiedene Strukturelemente enthalten.

14. Polyimide gemäss Anspruch 13, dadurch gekennzeichnet, dass sich die Strukturelemente der Formel I im Rest X unterscheiden.

15. Polyimide gemäss Anspruch 9, dadurch gekennzeichnet, dass X in Formel I Resten der Formeln

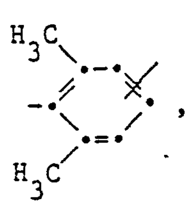, 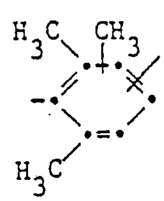, 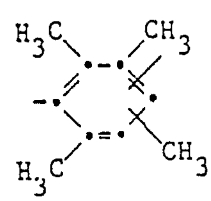, 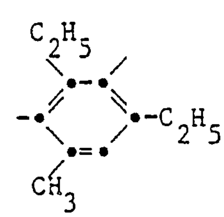

entsprechen, worin die freien Bindungen in Meta- oder Parastellung zueinander stehen, oder der Formel

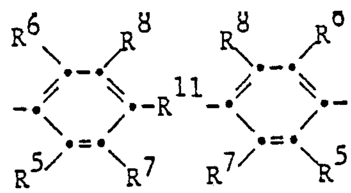

entsprechen, worin $R^5$ und $R^6$ unabhängig Methyl, Aethyl, n-Propyl oder Isopropyl und $R^7$ und $R^8$ ein Wasserstoffatom sind oder die Bedeutung von $R^5$ haben oder $R^5$ und $R^7$ zusammen Tri- oder Tetramethylen bedeuten und $R^6$ und $R^8$ ein Wasserstoffatom sind, und $R^{11}$ eine direkte Bindung, $CH_2$ oder CO ist.

16. Polyimide gemäss Anspruch 15, dadurch gekennzeichnet, dass es ein Copolyimid mit zwei oder mehr Resten der Formeln

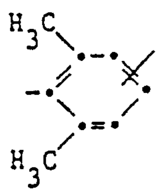 , 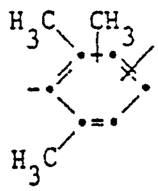 , 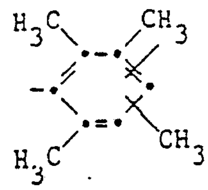 , 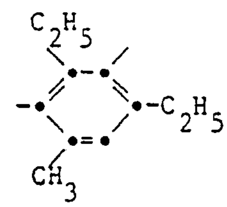

worin die freien Bindungen in Meta- oder Parastellung zueinander stehen, oder der Formel

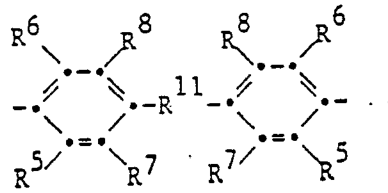

ist, worin $R^5$, $R^6$, $R^7$, $R^8$ und $R^{11}$ die im Anspruch 15 angegebene Bedeutung haben.

17. Polyimide gemäss Anspruch 1, dadurch gekennzeichnet, dass X′ in Formel II Alkylen mit 2 bis 30 C-Atomen, Cycloalkylen mit 5 bis 8 Ringkohlenstoffatomen, Aralkylen mit 7 bis 30 C-Atomen, Arylen mit 6 bis 22 C-Atomen oder ein Polysiloxanrest ist.

18. Polyimide gemäss Anspruch 17, dadurch gekennzeichnet, dass X′ als Arylen der Formel IV entspricht,

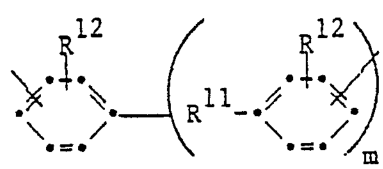

(IV)

worin m 0 oder 1 ist, die freien Bindungen in Meta- und bevorzugt in Orthostellung zur $R^{12}$-Gruppe gebunden sind, $R^{11}$ die gleiche Bedeutung wie in Formel IIIa hat und $R^{12}$ die gleiche Bedeutung wie $R^5$ hat.

19. Polyimide gemäss Anspruch 18, dadurch gekennzeichnet, dass X′ der Formel IVa, IVb und/oder IVc entspricht,

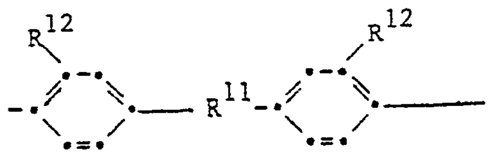 (IVa) , 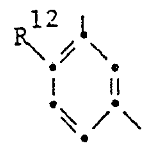 (IVb) ,

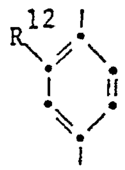 (IVc) ,

worin $R^{11}$ für eine direkte Bindung, -O-, -CO- oder $-CH_2-$ steht und $R^{12}$ Methyl, Aethyl, Isopropyl, Methoxy, Aethoxy oder ein Wasserstoffatom bedeutet.

20. Polyimide gemäss Anspruch 1, dadurch gekennzeichnet, dass sie 20-100 Mol% Strukturelemente der Formel I und 80-0 Mol% Strukturelemente der Formel II enthalten.

21. Verfahren zur Herstellung von Polyimiden gemäss Anspruch 1, das dadurch gekennzeichnet ist, dass man mindestens eine Tetracarbonsäure der Formel V

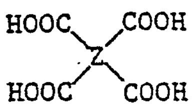 (V)

alleine oder zusammen mit mindestens einer Tetracarbonsäure der Formel Va, oder deren polyimidbildenden Derivate,

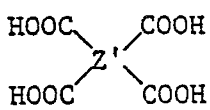 (Va)

mit mindestens 5 Mol-%, bezogen auf die Diamine, mindestens eines Diamines der Formel VI

$H_2N—X—NH_2$ (VI)

alleine oder zusammen mit höchstens 95 Mol-% mindestens eines Diamines der Formel VIa

$H_2—X'—NH_2$ (VIa),

worin Z, Z', X und X' die in Anspruch 1 definierte Bedeutung besitzen, in an sich bekannter Weise polykondensiert und anschliessend cyclisiert.

22. Beschichtetes Material aus einem Trägermaterial, auf dem eine Schicht eines Polyimides gemäss der Ansprüche 1 oder 21 aufgebracht ist.

23. Verwendung von Polyimiden gemäss Anspruch 1 zur Herstellung von Filmen und Schutzüberzügen.